Europäisches Patentamt

European Patent Office

Office européen des brevets

(19)

(11) Publication number : **0 498 567 A1**

(12) # EUROPEAN PATENT APPLICATION

(21) Application number : **92300784.3**

(22) Date of filing : **30.01.92**

(51) Int. Cl.⁵ : **H01L 27/118**

(30) Priority : **04.02.91 US 650123**

(43) Date of publication of application :
**12.08.92 Bulletin 92/33**

(84) Designated Contracting States :
**DE FR GB**

(71) Applicant : **MOTOROLA, INC.**
**1303 East Algonquin Road**
**Schaumburg, IL 60196 (US)**

(72) Inventor : **Lai, Stephen Wai-Yan**
**1648 E. Chicago Street**
**Chandler, Arizona 85225 (US)**

(74) Representative : **Lupton, Frederick et al**
**Motorola European Intellectual Property**
**Operations Jays Close Viables Industrial**
**Estate**
**Basingstoke, Hants RG22 4PD (GB)**

(54) **Mixed CMOS/BiCMOS device.**

(57) A gate array having an inner core area which has both CMOS and BiCMOS cells is presented. CMOS cells are advantageous for their low power dissipation and high density. On the other hand, BiCMOS cells have a performance advantage with their high current capability for driving large loads. Thus, a mix of both CMOS and BiCMOS cells can achieve the best design tradeoff for performance, density and power.

FIG. 1

EP 0 498 567 A1

Jouve, 18, rue Saint-Denis, 75001 PARIS

Background of the Invention

The present invention relates to integrated circuit devices, for example, an integrated circuit device including a mix of CMOS logic cells and BiCMOS logic cells.

Typically, a gate array includes inner (internal) core cells, peripheral cells and input/output (I/O) cells. The inner core cells are located in the middle or "core" of the array, while the I/O cells are located at the outer boundary of the gate array. Further, peripheral cells are typically located between the inner core cells and the I/O cells.

Internal core cells of a gate array typically contain only one type of cell such as CMOS cells or BiCMOS cells. CMOS cells have the advantages of lower power and higher density, while BiCMOS cells have the advantage of higher performance for driving large loads as is well understood in the art. As a result, it would be advantageous to have a gate array circuit that includes a mix of CMOS and BiCMOS cells to obtain the best design tradeoffs for performance, density and power.

One approach that has been made to obtain a gate array having a mix of CMOS and BiCMOS cells includes an inner core having all CMOS cells, while the I/O and peripheral cells include BiCMOS cells. This approach allows for a high density of CMOS cells in the inner core. However, the BiCMOS cells are limited to the boundary area of the inner core and, thus, are not available in the inner core of the gate array.

Another approach that has been made to obtain a gate array having a mix of cells includes an inner core that has a first-type and a second-type of cell. The first-type of cell includes P-type and N-type MIS transistors, while the second-type of cell includes NPN and PNP bipolar transistors. However, this approach does not include utilizing a BiCMOS cell which has both MIS transistors and bipolar transistors.

Hence, a need exists for a gate array circuit having an inner core of cells that includes a mix of CMOS and BiCMOS cells.

Summary of the Invention

Briefly, there is provided an inner core area of an integrated circuit device comprising a plurality of CMOS cells; a plurality of BiCMOS cells, the plurality of CMOS cells and the plurality of BiCMOS cells being mixed within the inner core area of the integrated circuit device.

It is an advantage of the present invention to provide a gate array circuit that has an inner core of cells including a mix of CMOS and BiCMOS cells. It is also an advantage of the present invention to provide a gate array circuit that is optimized with respect to performance, density and power by taking advantage of both CMOS and BiCMOS cells.

Brief Description of the Drawings

FIG. 1 is a gate array circuit including a mix of CMOS and BiCMOS cells in accordance with the present invention;
FIG. 2 is a detailed schematic diagram illustrating a simple NAND gate circuit; and
FIG. 3 is a portion of a gate array circuit for implementing a NAND gate circuit in accordance with the present invention.

Detailed Description of the Invention

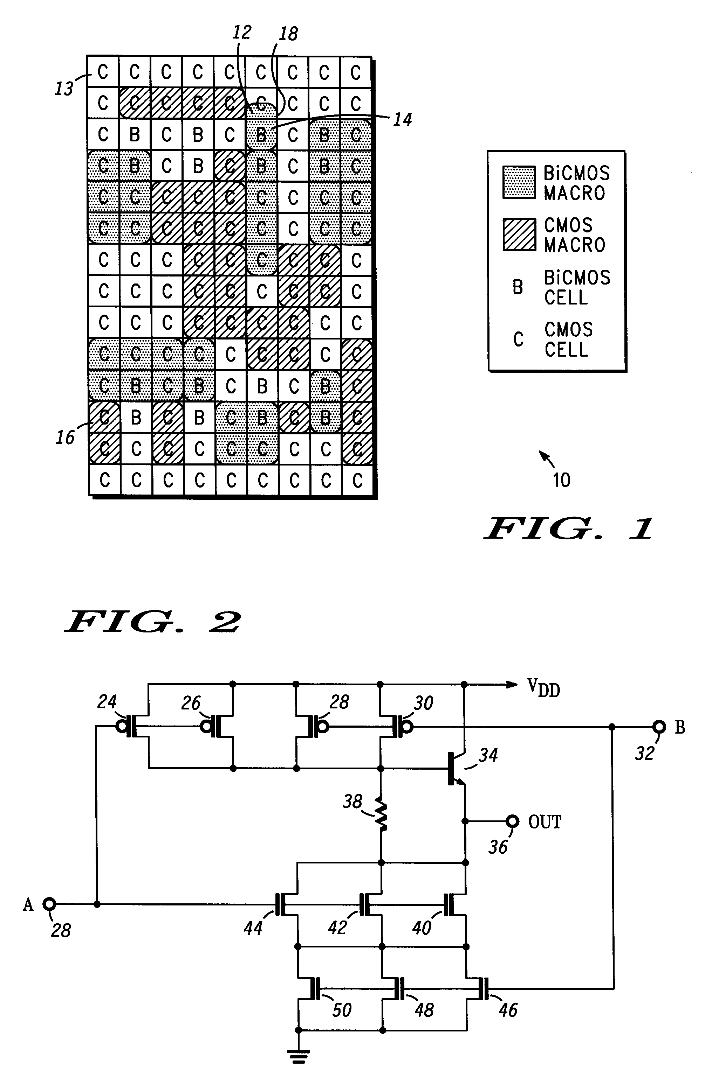

Referring to FIG. 1, an inner core area 10 of a gate array circuit includes a mix of a plurality of CMOS and BiCMOS cells. The CMOS cells are indicated by the blocks having the letter "C", for example blocks 12 and 13. A typical CMOS cell includes four P-type MOS transistors and four N-type MOS transistors. BiCMOS cells are indicated by the blocks having the letter "B", for example block 14 whereby a typical BiCMOS cell is formed from an existing CMOS cell where at least one pair of P-type transistors has been replaced by at least one bipolar transistor, for example a pair of NPN bipolar transistors. Inner core area 10 also includes a plurality of CMOS and BiCMOS macros wherein a CMOS macro includes a plurality of CMOS cells that are typically combined to perform a predetermined function, for example, cross hatched area 16. Likewise, a BiCMOS macro includes a plurality of BiCMOS cells that are typically combined to perform a predetermined function, for example, dotted area 18. Note that a BiCMOS macro can include both BiCMOS and CMOS cells, or just BiCMOS cells. Also note that a BiCMOS or CMOS macros can utilize one-half of a BiCMOS or CMOS cell as indicated by BiCMOS macro 18 which utilizes only one-half of CMOS cell 12. Further, it should be realized that inner core area 10 is not restricted to the configuration as shown in FIG. 1. In fact, the CMOS and BiCMOS cells of inner core area 10 can be mixed in any desired configuration so as to optimize performance, density and power for a particular application of the gate array circuit.

It is worth noting that a typical BiCMOS base cell such as cell 14 is designed and laid out in the same area of a typical CMOS base cell such as cell 13 wherein a BiCMOS cell is formed from an existing CMOS cell, as aforedescribed. That is, the parameters and boundaries of the CMOS base cell and those of the BiCMOS base cell are designed to match each other. In fact, a BiCMOS cell is configured from a typical CMOS cell by replacing P-type MOS transistors by bipolar transistors, as aforementioned. Thus, the BiCMOS base cell is "pitched-matched" to the CMOS base cell so that each type of cell can be placed adjacent to each other to form a sea-of-cell configuration. Further, the symmetry in the BiCMOS base cell layout and placement is an image-pair to the CMOS base cell layout, and allows for the full utilization of the sea-of-cell configuration in macro design, place and route. In addition, since the BiCMOS cells typically only consume a small percentage of inner core area 10 and a sea-of-gates including CMOS only arrays cannot achieve 100% usage, BiCMOS cells can be efficiently utilized throughout inner core area 10 while, theoretically, the same silicon efficiency is maintained for the CMOS cells. Therefore, an efficient use of CMOS and BiCMOS cells is achieved through this mix of CMOS/BiCMOS sea-of-cell core structure.

Referring to FIG. 2, a detailed schematic diagram illustrating a simple NAND gate circuit is shown comprising PMOS transistors 24 and 26 having their source electrodes coupled to a first supply voltage terminal at which the operating potential $V_{DD}$ is applied. The gate electrodes of PMOS transistors 24 and 26 are coupled to terminal 28 at which logic signal A is applied. The source electrodes of PMOS transistors 28 and 30 are coupled to operating potential $V_{DD}$ while the gate electrodes of PMOS transistors 28 and 30 are coupled to terminal 32 at which logic signal B is applied. The drain electrodes of PMOS transistors 28 and 30 are coupled to the drain electrodes of PMOS transistors 24 and 26 and to the base of bipolar transistor 34. The collector of bipolar transistor 34 is coupled to operating potential $V_{DD}$, while the emitter of bipolar transistor 34 is coupled to terminal 36 at which output logic signal OUT is provided. Resistor 38 is coupled across the base and emitter of bipolar transistor 34. The drain electrodes of NMOS transistors 40, 42 and 44 are all coupled to the emitter of bipolar transistor 34. The gate electrodes of NMOS transistors 40, 42 and 44 are all coupled to terminal 28, while the source electrodes of NMOS transistors 40, 42 and 44 are all coupled to the drain electrodes of NMOS transistors 46, 48 and 50. The gate electrodes of NMOS transistors 46, 48 and 50 are coupled to terminal 32, while the source electrodes of NMOS transistors 46, 48 and 50 are returned to ground.

The operation of the NAND gate circuit shown in FIG. 2 is such that when a logic high is applied to terminals 28 and 32, a logic low appears at terminal 36. Further, if a logic 0 is applied to either terminal 28 or terminal 32 or both terminals 28 and 32, then a logic high appears at terminal 36. It is worth noting that transistors 24 and 26, transistors 28 and 30, transistors 40, 42 and 44, and transistors 46, 48 and 50 have been placed in parallel as shown in order to achieve increased drive capability. Also, it is understood that the operation of the NAND gate circuit of FIG. 2 would be obvious to one of ordinary skill in the art and, thus, no more explanation is needed.

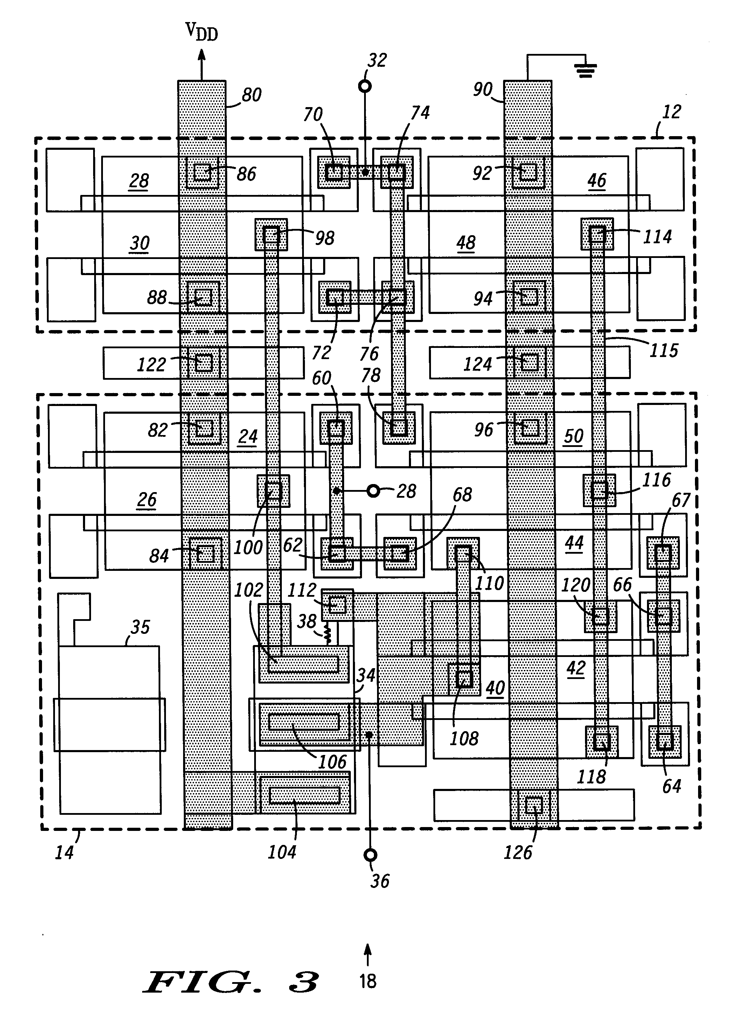

Referring to FIG. 3, BiCMOS macro 18 of FIG. 1 is shown in detail as an example to implement the NAND gate circuit shown in FIG. 2. It is understood that components similar to those shown in FIGs. 1 and 2 are designated by similar reference numerals. BiCMOS macro 18 includes one-half of CMOS cell 12 and BiCMOS cell 14. Thus, a full CMOS cell would be twice as large as shown in block 12 of FIG. 3 such that a typical CMOS cell would include two more additional P-type MOS transistors similar to transistors 28 and 30, and two more additional N-type MOS transistors similar to transistors 46 and 48. In addition, BiCMOS cell 14 is shown whereby two existing P-type MOS transistors of a typical CMOS cell have been replaced by two bipolar type transistors (transistors 34 and 35). Transistors 24, 26, 40, 42 and 44 all have their gate electrodes coupled to terminal 28 via metal contacts 60, 62, 64, 66, 67 and 68, respectively. Likewise, transistors 28, 30, 46, 48 and 50 all have their gate electrodes coupled to terminal 32 via metal contacts 70, 72, 74, 76 and 78, respectively. Transistors 24, 26, 28 and 30 all have their source electrodes coupled to $V_{DD}$ metal bus 80 via metal contacts 82, 84, 86 and 88, respectively. Likewise, transistors 46, 48 and 50 all have their source electrodes coupled to ground metal bus 90 via metal contacts 92, 94 and 96, respectively. The common drain electrodes of transistors 28 and 30 are coupled to the common drain electrodes of transistors 24 and 26 and to the base of bipolar transistor 34 via a metal layer having contacts 98, 100 and 102, respectively. The collector of bipolar transistor 34 is coupled to $V_{DD}$ metal bus 80 via metal contact 104. The emitter of bipolar transistor 34 is coupled to the drain electrodes of transistors 40, 42 and 44 via a metal layer having contacts 106, 108 and 110, respectively, whereby metal contact 108 is coupled to the common drain electrodes of transistors 40 and 42. Further, resistor 38 is shown coupled between the base and emitter of bipolar transistor 34 via metal contacts 102 and 112, respectively. The emitter of bipolar transistor 34 is also coupled to terminal 36. The common drain electrodes of transistors 46 and 48 at metal contact 114 is coupled by metal layer 115 to the drain electrode of transistor 50 and to the source electrode of transistor 44 via metal contact 116. Metal layer 115 also couples the source electrodes of transistors 40 and 42 via metal contacts 118 and 120, respectively, to the source of transistor 44 (metal contact 116). Further, metal contact 122 couples an N-well for P-type transistors 24, 26, 28 and 30 and for bipolar transistor 34 to operating potential $V_{DD}$. Likewise, metal contacts 124 and 126 couples a P-well (substrate) for N-type transistors 40, 42, 44, 46, 48 and 50 to ground reference. It is worth noting that bipolar transistor 35 is not being utilized by BiCMOS macro 18 for implementing the NAND gate circuit. However, another application may very well use bipolar transistor 35.

It should be understood that a NAND gate circuit is only one implementation for BiCMOS macro 18.

Further, various mixes of CMOS and BiCMOS cells can be utilized for performing a variety of macro functions such as an inverter circuit, a NOR gate circuit or a flip-flop circuit.

By now it should be apparent from the foregoing discussion that a novel gate array circuit has been provided having an inner core area that includes a mix of both CMOS and BiCMOS cells.

**Claims**

1. An inner core area of an integrated circuit device, comprising:
   a plurality of CMOS cells (13), each one of said plurality of CMOS cells including at least one P-type MOS transistor and at least one N-type MOS transistor; and
   a plurality of BiCMOS cells (14), each of said plurality of BiCMOS cells including at least one N-type MOS transistors and at least one bipolar transistor, said plurality of CMOS cells and said plurality of BiCMOS cells being mixed within the inner core area of the integrated circuit device.

2. The inner core area of the integrated circuit device according to claim 1 wherein a first portion of said plurality of CMOS cells is configured to implement a plurality of CMOS macros (16) and a portion of said plurality of BiCMOS cells is combined with a second portion of said plurality of CMOS cells which are configured to implement a plurality of BiCMOS macros (18).

3. The inner core area of the integrated circuit device according to claim 1 wherein a first portion of said plurality of CMOS cells is configured to implement a plurality of CMOS macros and a portion of said plurality of BiCMOS cells is is configured to implement a plurality of BiCMOS macros.

4. The inner core area of the integrated circuit device according to claims 2 or 3 wherein at least one of said plurality of CMOS macros includes one-half of one of said plurality of CMOS cells.

5. The inner core area of the integrated circuit device according to claims 2 or 3 wherein at least one of said plurality of BiCMOS macros includes one-half of one of said plurality of CMOS cells or one-half of one of said plurality of BiCMOS cells.

6. The inner core area of the integrated circuit device according to claim 1 wherein said plurality of BiCMOS cells are pitched-matched to said plurality of CMOS cells.

7. An inner core area of an integrated circuit device, comprising:
   a plurality of P-type MOS transistors (28, 30, 24, 26);
   a plurality of N-type MOS transistors (46, 48, 50, 40, 42, 44);
   a plurality of bipolar NPN transistors (34, 35);
   a plurality of CMOS cells (12), each one of said plurality of CMOS cells including a first predetermined number of said P-type MOS transistors and said N-type MOS transistors; and
   a plurality of BiCMOS cells (14), each one of said plurality of BiCMOS cells including a second predetermined number of said P-type MOS transistors, a third predetermined number of said N-type MOS transistors and a fourth predetermined number of said bipolar NPN transistors, said plurality of CMOS cells and said plurality of BiCMOS cells being mixed within the inner core area of the integrated circuit device.

8. The inner core area of an integrated circuit device according to claim 7 wherein at least one of said plurality of CMOS macros includes one-half of one of said plurality of CMOS cells.

9. The inner core area of an integrated circuit device according to claim 7 wherein at least one of said plurality of BiCMOS macros includes one-half of one of said plurality of BiCMOS cells.

**FIG. 1**

Legend:
- BiCMOS MACRO
- CMOS MACRO
- B  BiCMOS CELL
- C  CMOS CELL

**FIG. 2**

FIG. 3

EP 0 498 567 A1

## European Patent Office

# EUROPEAN SEARCH REPORT

Application Number

EP 92 30 0784

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | ELECTRONICS. vol. 61, no. 3, 4 February 1988, NEW YORK US pages 63 - 64; S. WEBER: 'LSI logic arrays boost both drive and density' | 1,7 | H01L27/118 |
| A | * page 63, left column, paragraph 5 - page 64, left column, paragraph 2; figures 1-2 * | 3,9 | |
| X | PATENT ABSTRACTS OF JAPAN vol. 13, no. 26 (E-706)(3374) 20 January 1989 & JP-A-63 228 641 ( HITACHI LTD. ) 22 September 1988 * abstract * | 1,7 | |
| P,X | EP-A-0 439 301 (HITACHI LTD.) 31 July 1991 * page 8, column 13, line 20 - page 8, column 14, line 43; claims 1-2,4; figures 3A-3B * | 1,6,7 | |
| | | | TECHNICAL FIELDS SEARCHED (Int. Cl.5 ) |
| | | | H01L |

The present search report has been drawn up for all claims

| Place of search | Date of completion of the search | Examiner |
|---|---|---|
| THE HAGUE | 16 APRIL 1992 | FRANSEN L.J.L. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................................

& : member of the same patent family, corresponding document

EPO FORM 1503 03.82 (P0401)

7